(19) Europäisches Patentamt
European Patent Office
Office européen des brevets

(11) **EP 4 351 293 A1**

(12) **EUROPEAN PATENT APPLICATION**
published in accordance with Art. 153(4) EPC

(43) Date of publication:
**10.04.2024 Bulletin 2024/15**

(21) Application number: **22815777.2**

(22) Date of filing: **02.05.2022**

(51) International Patent Classification (IPC):
*H05K 9/00* (2006.01)     *B32B 7/025* (2019.01)
*B32B 15/08* (2006.01)     *H01F 1/26* (2006.01)

(52) Cooperative Patent Classification (CPC):
**B32B 7/025; B32B 15/08; H01F 1/26; H05K 9/00**

(86) International application number:
**PCT/JP2022/019488**

(87) International publication number:
**WO 2022/255022 (08.12.2022 Gazette 2022/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.05.2021 JP 2021091630**

(71) Applicant: **FUJIFILM Corporation
Tokyo 106-8620 (JP)**

(72) Inventor: **FUKAGAWA, Kiyotaka
Minamiashigara-shi, Kanagawa 250-0193 (JP)**

(74) Representative: **Klunker IP
Patentanwälte PartG mbB
Destouchesstraße 68
80796 München (DE)**

(54) **ELECTOMAGNETIC WAVE SHIELDING MATERIAL, ELECTRONIC COMPONENT, AND ELECTRONIC APPARATUS**

(57) There is provided an electromagnetic wave shielding material including one or more magnetic layers, two or more metal layers, and two or more resin layers, in which each of the included one or more layers of the magnetic layers is a magnetic layer sandwiched between two metal layers, where the magnetic layer is also sandwiched between two resin layers.

EP 4 351 293 A1

**Description**

[Field of the Invention]

The present invention relates to an electromagnetic wave shielding material, an electronic component, and an electronic apparatus.

[Background art]

In recent years, an electromagnetic wave shielding material has attracted attention as a material for reducing the influence of an electromagnetic wave in various electronic components and various electronic apparatuses (see, for example, PTL 1 and PTL 2).

[Citation list]

[Patent literature]

[PTL 1] JP1991-6898A (JP-H3-6898A)
[PTL 2] JP2008-192792A

[Summary of the invention]

[Problems to be solved by the invention]

An electromagnetic wave shielding material (hereinafter, also described as a "shielding material") is capable of exhibiting performance of shielding electromagnetic waves (shielding ability) by reflecting electromagnetic waves incident on the shielding material by the shielding material and/or by attenuating the electromagnetic waves in the inside the shielding material.
The following two performances can be mentioned as the performance desired for the electromagnetic wave shielding material.
The first is that a high shielding ability can be exhibited against electromagnetic waves. An electromagnetic wave shielding material that exhibits a high shielding ability against electromagnetic waves is desirable since it can contribute to significantly reducing the influence of electromagnetic waves on an electronic component and an electronic apparatus. Regarding this point, according to the study by the inventors of the present invention, further improvement in the shielding ability against particularly a magnetic field wave among electromagnetic waves is desired in the electromagnetic wave shielding materials in the related art.
The second is that forming workability is excellent. The electromagnetic wave shielding material can be processed into various shapes in order to be incorporated into an electronic component or an electronic apparatus. It can be said that the excellent forming workability refers to that the defects such as a shape defect and breakage are less likely to occur in forming. An electromagnetic wave shielding material having excellent forming workability is desirable from the viewpoint that a formed article is less likely to be broken in a case where a shape of a forming die is reproduced in the formed article by three-dimensional forming (in other words, forming in three dimensions) such as vacuum forming or air pressure forming described in, for example, JP2008-192792A (PTL 2).
In consideration of the above circumstances, an object of one aspect of the present invention is to provide an electromagnetic wave shielding material that is capable of exhibiting a high shielding ability against electromagnetic waves particularly against a magnetic field wave and is excellent in forming workability.

[Means for solving problems]

One aspect of the present invention relates to:

an electromagnetic wave shielding material including;
one or more magnetic layers,
two or more metal layers, and
two or more resin layers,
in which each of the included one or more layers of the magnetic layers is a magnetic layer sandwiched between two metal layers, where the magnetic layer is also sandwiched between two resin layers.

In one form, the total number of the magnetic layers included in the electromagnetic wave shielding material is such that one layer can be included, where the thickness of the magnetic layer can be 10 $\mu$m or more.

In one form, the magnetic layer can satisfy the following relational expression together with one or both of two resin layers that sandwich the magnetic layer, in a case where a thickness per one layer of the magnetic layer is denoted as Dm and a thickness per one layer of the resin layer is denoted as Dp.

$$0.17 \leq \mathrm{Dp/Dm} \leq 25.00.$$

In one form, the total number of the magnetic layers included in the electromagnetic wave shielding material is such that two or more layers can be included, where the thickness of each of the two or more magnetic layers can be 10 $\mu$m or more.

In one form, one or more layers in the two or more magnetic layers can satisfy the following relational expression together with one or both of two resin layers that sandwich the magnetic layer, in a case where a thickness per one layer of the magnetic layer is denoted as Dm and a thickness per one layer of the resin layer is denoted as Dp.

$$0.17 \leq \mathrm{Dp/Dm} \leq 25.00.$$

In one form, the glass transition temperature of the resin layer can be 50°C or higher.

In one form, in the two or more metal layers included in the electromagnetic wave shielding material, both the metal layer positioned on one outermost side and the metal layer positioned on the other outermost side can be layers adjacent to the resin layer.

In one form, the magnetic layer can be a layer containing metal particles as the magnetic particles.

In one form, the magnetic layer can be a layer further containing a resin.

One aspect of the present invention relates to an electronic component including the electromagnetic wave shielding material.

One aspect of the present invention relates to an electronic apparatus including the electromagnetic wave shielding material.

[Effects of the invention]

According to one aspect of the present invention, it is possible to provide an electromagnetic wave shielding material that is capable of exhibiting a high shielding ability against electromagnetic waves particularly against a magnetic field wave and is excellent in forming workability. In addition, according to one aspect of the present invention, it is possible to provide an electronic component and an electronic apparatus, which include the electromagnetic wave shielding material.

[Description of the embodiments]

[Electromagnetic wave shielding material]

One aspect of the present invention relates to an electromagnetic wave shielding material including one or more magnetic layers, two or more metal layers, and two or more resin layers. The electromagnetic wave shielding material includes one or more layers, each of which is a magnetic layer sandwiched between two metal layers, where the magnetic layer is also sandwiched between two resin layers.

In the present invention and the present specification, the "electromagnetic wave shielding material" shall refer to a material that is capable of exhibiting a shielding ability against an electromagnetic wave of at least one frequency or at least a part of a frequency band. The "electromagnetic wave" includes a magnetic field wave and an electric field wave. The "electromagnetic wave shielding material" is preferably a material that is capable of exhibiting a shielding ability against one or both a magnetic field wave of at least one frequency or at least a part of a frequency band and an electric field wave of at least one frequency or at least a part of a frequency band, and it is more preferably a material that is capable of exhibiting a shielding ability against a magnetic field wave in a wider frequency band and/or an electric field wave in a wider frequency band, where it is more preferable that a higher shielding ability can be exhibited.

In the present invention and the present specification, the "magnetic layer" shall refer to a layer containing a magnetic material. In the present invention and the present specification, "magnetic" means having a ferromagnetic property. Details of the magnetic layer will be described later.

In the present invention and the present specification, the "metal layer" shall refer to a layer containing a metal. The metal layer can be a layer containing one or more kinds of metals as a pure metal consisting of a single metal element, as an alloy of two or more kinds of metal elements, or as an alloy of one or more kinds of metal elements and one or more kinds of non-metal elements. Details of the metal layer will be described later.

In the present invention and the present specification, the "resin layer" shall refer to a layer containing a resin. In the present invention and the present specification, the"resin" means a polymer, and it shall include rubber and an elastomer as well. The polymer includes a homopolymer and a copolymer. The rubber includes natural rubber and synthetic rubber. The elastomer is a polymer that exhibits elastic deformation. Details of the resin layer will be described later.

The thickness of each layer included in the electromagnetic wave shielding material shall be determined by imaging a cross section exposed by a known method with a scanning electron microscope (SEM) and determining an arithmetic average of thicknesses of five randomly selected points in the obtained SEM image.

The electromagnetic wave shielding material includes one or more layers, each of which is a magnetic layer sandwiched between two metal layers, where the magnetic layer is also sandwiched between two resin layers. That is, the electromagnetic wave shielding material has one layer or two or more layers of the magnetic layer that is positioned between the two metal layers and between the two resin layers. The inventors of the present invention presume that the reason why the electromagnetic wave shielding material is capable of exhibiting a high shielding ability against electromagnetic waves is due to the fact that the electromagnetic wave shielding material has a multilayer structure in which a magnetic layer is sandwiched between two metal layers. The details are as follows. In order to obtain a high shielding ability against electromagnetic waves in the electromagnetic wave shielding material, it is desirable to increase the reflection at the interface in addition to increasing the ability to attenuate electromagnetic waves. That is, it is desirable that the electromagnetic wave repeatedly reflects at the interface and passes through the shielding material a large number of times to be largely attenuated. However, as the behavior of the metal layer and the magnetic layer with respect to the electromagnetic wave, the reflection of the magnetic field wave at the interface tends to be small although the metal layer has a large ability to attenuate the electromagnetic wave, and the reflection of the magnetic field wave at the interface tends to be larger than that in the metal layer although the magnetic layer has a smaller ability to attenuate the electromagnetic wave than the metal layer. Therefore, with the metal layer alone or the magnetic layer alone, it is difficult to achieve both high reflection and high attenuation of, particularly, the magnetic field wave among the electromagnetic waves. On the other hand, due to including a multilayer structure having the magnetic layer between two metal layers, the electromagnetic wave shielding material makes it possible to achieve both the above-described reflection at the interface and the above-described attenuation within the layer. The inventors of the present invention conceive this fact is the reason why the electromagnetic wave shielding material is capable of exhibiting a high shielding ability against magnetic field waves. However, the present invention is not limited to the presumption described in the present specification.

Further, the inventors of the present invention presume that the reason why the electromagnetic wave shielding material can exhibit excellent forming workability is due to the fact that the electromagnetic wave shielding material has a multilayer structure in which a magnetic layer is sandwiched between two resin layers. The inventors of the present invention presume that this is because the resin layers positioned on both sides of the magnetic layer play a role of relaxing the stress applied to the magnetic layer during forming. Further, the inventors of the present invention presume that in the electromagnetic wave shielding material, the resin layer can also play a role of relaxing the stress applied to the metal layer. It is conceived that the relaxation of the stress applied to each layer by the resin layer in this way can contribute to, for example, suppressing the occurrence of the breakage in a case of forming a sheet-shaped object to be formed into a three-dimensional structure.

Hereinafter, the electromagnetic wave shielding material will be described in more detail.

<Magnetic layer>

(Magnetic material)

The magnetic layer is a layer containing a magnetic material. Examples of the magnetic material include magnetic particles. As the magnetic particle, one kind selected from the group consisting of magnetic particles generally called soft magnetic particles, such as metal particles and ferrite particles, can be used, or two or more kinds therefrom can be used in combination. Since the metal particles generally have a saturation magnetic flux density of about 2 to 3 times as compared with ferrite particles, the metal particles can maintain specific magnetic permeability and exhibit shielding ability even under a strong magnetic field without magnetic saturation. Therefore, the magnetic particles to be contained in the magnetic layer are preferably metal particles. In the present invention and the present specification, a layer containing metal particles as the magnetic material shall correspond to the "magnetic layer".

Metal particle

Examples of the metal particles as the magnetic material include particles of Sendust (an Fe-Si-Al alloy), a permalloy (an Fe-Ni alloy), a molybdenum permalloy (an Fe-Ni-Mo alloy), a Fe-Si alloy, a Fe-Cr alloy, an Fe-containing alloy generally called the iron-based amorphous alloy, a Co-containing alloys generally called the cobalt-based amorphous alloy, an alloy generally called the nanocrystal alloy, iron, Permendur (an Fe-Co alloy). Among them, Sendust is preferable since it exhibits a high saturation magnetic flux density and a high specific magnetic permeability. The metal particle may contain, in addition to the constitutional element of the metal (including the alloy), elements contained in an additive that can be optionally added and/or elements contained in impurities that can be unintentionally mixed in a manufacturing process of the metal particle at any content. In the metal particle, the content of the constitutional element of the metal (including the alloy) is preferably 90.0% by mass or more and more preferably 95.0% by mass or more, and it may be 100% by mass or may be less than 100% by mass, 99.9% by mass or less, or 99.0% by mass or less.

In one form, a magnetic layer exhibiting a high magnetic permeability (specifically, a real part of a complex specific magnetic permeability) is preferable. In a case where a complex specific magnetic permeability is measured by a magnetic permeability measuring apparatus, a real part $\mu'$ and an imaginary part $\mu'$ are generally displayed. In the present invention and the present specification, a real part of a complex specific magnetic permeability shall refer to such a real part $\mu'$. Hereinafter, a real part of a complex specific magnetic permeability at a frequency of 100 kHz is also simply referred to as "magnetic permeability". The magnetic permeability can be measured by a commercially available magnetic permeability measuring apparatus or a magnetic permeability measuring apparatus having a known configuration. From the viewpoint that still more excellent electromagnetic wave shielding ability can be exhibited, it is preferable that the magnetic layer positioned between the two metal layers and between the two resin layers is a magnetic layer having a magnetic permeability (the real part of the complex specific magnetic permeability at a frequency of 100 kHz) of 30 or more. The magnetic permeability thereof is more preferably 40 or more, still more preferably 50 or more, still more preferably 60 or more, even more preferably 70 or more, even still more preferably 80 or more, even still more preferably 90 or more, and even further still more preferably 100 or more. In addition, the magnetic permeability can be, for example, 200 or less, 190 or less, 180 or less, 170 or less, or 160 or less, and it can exceed the values exemplified here. The higher the magnetic permeability is, the higher interfacial reflection effect is obtained, which is preferable.

From the viewpoint of forming a magnetic layer exhibiting a high magnetic permeability, the magnetic particle is preferably a particle having a flat shape (flat-shaped particle). In a case of arranging the long side direction of the flat-shaped particles to be closer to a state parallel to the in-plane direction of the magnetic layer, the magnetic layer can exhibit a higher magnetic permeability since the diamagnetic field can be reduced by aligning the long side direction of the particle with the vibration direction of the electromagnetic wave incident orthogonal to the electromagnetic wave shielding material. In the present invention and the present specification, the "flat-shaped particle" refers to a particle having an aspect ratio of 0.20 or less. The aspect ratio of the flat-shaped particles is preferably 0.15 or less, and more preferably 0.10 or less. The aspect ratio of the flat-shaped particles can be, for example, 0.01 or more, 0.02 or more, or 0.03 or more. It is possible to make the shape of the particle flat-shaped by carrying out the flattening process according to a known method. For the flattening process, for example, the description of JP2018-131640A can be referenced, and specifically, the description of paragraphs 0016 and 0017 and the description of Examples of the same publication can be referenced. Examples of the magnetic layer exhibiting a high magnetic permeability include a magnetic layer containing flat-shaped particles of Sendust.

As described above, from the viewpoint of forming a layer exhibiting a high magnetic permeability as the magnetic layer, it is preferable to arrange the long side direction of the flat-shaped particles to be closer to a state parallel to the in-plane direction of the magnetic layer. From this point, the alignment degree which is a sum of an absolute value of the average value of alignment angles of the flat-shaped particles with respect to the surface of the magnetic layer and a variance of the alignment angles is preferably 30° or lower, more preferably 25° or lower, still more preferably 20° or lower, and particularly preferably 15° or lower. The alignment degree can be, for example, 3° or higher, 5° or higher, or 10° or higher, and it can be lower than the values exemplified here. A method of controlling the alignment degree will be described later.

In the present invention and the present specification, the aspect ratio of the magnetic particle and the alignment degree are determined according to the following methods.

A cross section of a magnetic layer is exposed according to a known method. A cross-sectional image is acquired as an SEM image regarding a randomly selected region of the cross-section. The imaging conditions are set to be an acceleration voltage of 2 kV and a magnification of 1,000 times, and an SEM image is obtained as the backscattered electron image.

Reading is carried out in grayscale with the cv2. imread () function of Image processing library OpenCV 4 (manufactured by Intel Corporation) by setting the second argument to 0, and a binarized image is obtained with the cv2. threshold () function, using an intermediate brightness between the high-brightness portion and the low-brightness portion as a boundary. A white portion (high-brightness portion) in the binarized image is defined as a magnetic particle.

Regarding the obtained binarized image, a rotational circumscribed rectangular shape corresponding to a portion of each magnetic particle is determined according to the cv2. minAreaRect () function, and the long side length, the short side length, and the rotation angle are determined as the return values of the cv2. minAreaRect () function. In a case of determining the total number of magnetic particles included in the binarized image, it shall be assumed that particles in which only a part of the particle is included in the binarized image are also included. Regarding the particles in which only a part of the particle is included in the binarized image, the long side length, the short side length, and the rotation angle of the portion included in the binarized image are determined. The ratio of the short side length to the long side length (short side length/long side length) determined in this way shall be denoted as the aspect ratio of each magnetic particle. In the present invention and the present specification, in a case where the number of magnetic particles which have an aspect ratio of 0.20 or less and is defined as flat-shaped particles is 10% on a number basis with respect to the total number of magnetic particles included in the binarized image, it shall be determined that the magnetic layer is a "magnetic layer including flat-shaped particles as the magnetic particles". In addition, from the rotation angle determined as above, an "alignment angle" is determined as a rotation angle with respect to a horizontal plane (the surface of the magnetic layer).

Particles having an aspect ratio of 0.20 or less, which are determined in the binarized image, are defined as flat-shaped particles. Regarding the alignment angles of all the flat-shaped particles included in the binarized image, the sum of the absolute value of the average value (arithmetic average) and the variance is determined. The sum determined in this way is referred to as the "alignment degree". It is noted that the coordinates of the circumscribed rectangle are calculated using the cv2. boxPoints () function, and an image in which the rotational circumscribed rectangle is superposed on the original image is created according to the cv2. drawContours () function, where a rotational circumscribed rectangle that is erroneously detected clearly is excluded from the calculation of the aspect ratio and the alignment degree. In addition, an average value (arithmetic average) of the aspect ratios of the particles defined as the flat-shaped particles shall be denoted as the aspect ratio of the flat-shaped particles to be contained in a magnetic layer to be measured. Such an aspect ratio is 0.20 or less, preferably 0.15 or less, and more preferably 0.10 or less. In addition, the aspect ratio can be, for example, 0.01 or more, 0.02 or more, or 0.03 or more.

The content of the magnetic particles in the magnetic layer is, for example, 50% by mass or more, 60% by mass or more, 70% by mass or more, and 80% by mass or more with respect to the total mass of the magnetic layer, and it can be, for example, 100% by mass or less, 98% by mass or less, or 95% by mass or less.

In one form, as the magnetic layer, a sintered body (a ferrite plate) of ferrite particles or the like can be used. Considering that there is a case where the electromagnetic wave shielding material is cut out to a desired size, a case where the electromagnetic wave shielding material is bent into a desired shape, and the like, the magnetic layer is preferably a layer that contains a resin as compared with a ferrite plate which is a sintered body.

In one form, the magnetic layer positioned between the two metal layers and between the two resin layers can be a layer having insulating properties. In the present invention and the present specification, the "insulating properties" means that the electrical conductivity is smaller than 1 siemens (S)/m. The electrical conductivity of a certain layer is calculated according to the following expression from the surface electrical resistivity of the layer and the thickness of the layer. The electrical conductivity can be measured by a known method.

$$\text{Electrical conductivity [S/m]} = 1/(\text{surface electrical resistivity } [\Omega] \times \text{thickness [m]})$$

The inventors of the present invention presume that it is preferable that the magnetic layer is a layer having insulating properties in order for the electromagnetic wave shielding material to exhibit a higher electromagnetic wave shielding ability. From this point, the electrical conductivity of the magnetic layer is preferably smaller than 1 S/m, more preferably 0.5 S/m or less, still more preferably 0.1 S/m or less, and even still more preferably 0.05 S/m or less. The electrical conductivity of the magnetic layer can be, for example, $1.0 \times 10^{-12}$ S/m or more or $1.0 \times 10^{-10}$ S/m or more.

(Resin)

The magnetic layer can be a layer containing a resin, and it can be a layer containing a magnetic material and a resin. In the present invention and the present specification, a layer containing both a magnetic material and a resin shall correspond to the "magnetic layer". In the magnetic layer containing the magnetic material and the resin, the content of the resin can be, for example, 1 part by mass or more, 3 parts by mass or more, or 5 parts by mass or more per 100 parts by mass of the magnetic material, and it can be 20 parts by mass or less or 15 parts by mass or less.

The resin can act as a binder in the magnetic layer. Examples of the resin to be contained in the magnetic layer include known thermoplastic resins in the related art, a thermosetting resin, an ultraviolet curable resin, a radiation curable resin, a rubber-based material, and an elastomer. Specific examples thereof include a polyester resin, a polyethylene resin, a polyvinyl chloride resin, a polyvinyl butyral resin, a polyurethane resin, a polyester urethane resin, a cellulose resin, an acrylonitrile-butadiene-styrene (ABS) resin, a nitrile-butadiene rubber, a styrene-butadiene rubber, an epoxy resin, a phenol resin, an amide resin, a silicone resin, a styrene-based elastomer, an olefin-based elastomer, a vinyl chloride-based elastomer, a polyester-based elastomer, a polyamide-based elastomer, a polyurethane-based elastomer, and an acrylic elastomer.

In addition to the above-described components, the magnetic layer can also contain any amount of one or more known additives such as a curing agent, a dispersing agent, a stabilizer, and a coupling agent.

<Metal layer>

The electromagnetic wave shielding material has a multilayer structure including a magnetic layer between the two metal layers and between the two resin layers. The electromagnetic wave shielding material includes one or more such multilayer structures and can also include two or more such multilayer structures. That is, the electromagnetic wave shielding material includes at least two metal layers and can also include three or more metal layers, it includes at least two resin layers and can also include three or more resin layers, or it includes at least one magnetic layer and can also include two or more magnetic layers. The two or three or more metal layers included in the electromagnetic wave shielding material have the same composition and thickness in one form and differ in composition and/or thickness in another form. The two or three or more resin layers included in the electromagnetic wave shielding material have the same composition and thickness in one form and differ in composition and/or thickness in another form. In addition, in a case where the electromagnetic wave shielding material includes two or more layers of the magnetic layer, the two or more magnetic layers have the same composition and thickness in one form and differ in composition and/or thickness in another form.

As the metal layer, a layer containing one or more kinds of metals selected from the group consisting of various pure metals and various alloys can be used. The metal layer can exhibit an attenuation effect in the shielding material. Since the attenuation effect increases as the propagation constant increases and the propagation constant increases as the electrical conductivity increases, it is preferable that the metal layer contains a metal element having a high electrical conductivity. From this point, it is preferable that the metal layer contains a pure metal of Ag, Cu, Au, or Al, or an alloy containing any one of these as a main component. The pure metal is a metal consisting of a single metal element and may contain a trace amount of impurities. In general, a metal having a purity of 99.0% or more consisting of a single metal element is called a pure metal. The purity is based on mass. The alloy is generally prepared by adding one or more kinds of metal elements or non-metal elements to a pure metal to adjust the composition, for example, in order to prevent corrosion or improve the hardness. The main component in the alloy is a component having the highest ratio on a mass basis, and it can be, for example, a component that occupies 80.0% by mass or more (for example, 99.8% by mass or less) in the alloy. From the viewpoint of economic efficiency, the alloy is preferably an alloy of a pure metal of Cu or Al or an alloy containing Cu or Al as a main component, and from the viewpoint of high electrical conductivity, it is preferably an alloy of a pure metal of Cu or an alloy containing Cu as a main component.

The purity of the metal in the metal layer, that is, the content of the metal can be 99.0% by mass or more, where it is preferably 99.5% by mass or more, and more preferably 99.8% by mass or more with respect to the total mass of the metal layer. Unless otherwise specified, the content of metal in the metal layer shall refer to the content on a mass basis. For example, as the metal layer, a pure metal or an alloy processed into a sheet shape can be used. For example, as the metal layer, a commercially available metal foil or a metal foil produced by a known method can be used. Regarding a pure metal of Cu, sheets (so-called copper foils) having various thicknesses are commercially available. For example, such a copper foil can be used as the metal layer. The copper foil includes, according to manufacturing methods thereof, an electrolytic copper foil obtained by precipitating a copper foil on a cathode by electroplating and a rolled copper foil obtained by applying heat and pressure to an ingot and stretching the ingot thinly. Any copper foil can be used as the metal layer of the electromagnetic wave shielding material. In addition, for example, regarding Al, sheets (so-called aluminum foils) having various thicknesses are commercially available. For example, such an aluminum foil can be used as the metal layer.

From the viewpoint of reducing the weight of the electromagnetic wave shielding material, one or both (preferably both) of the two metal layers included in the multilayer structure is preferably a metal layer containing a metal selected from the group consisting of Al and Mg. This is because a value (specific gravity/electrical conductivity) obtained by dividing the specific gravity by the electrical conductivity is small both in Al and Mg. As a metal in which this value is smaller is used, the weight of the electromagnetic wave shielding material exhibiting a high shielding ability can be further reduced. As a value calculated from the literature value, for example, a value (specific gravity/electrical conductivity) obtained by dividing the specific gravity by the electrical conductivity of each of Cu, Al, and Mg is as follows. Cu: $1.5 \times 10^{-7}$ m/S, Al: $7.6 \times 10^{-8}$ m/S, Mg: $7.6 \times 10^{-8}$ m/S. From the above values, it can be said that Al and Mg are preferred metals from the viewpoint of reducing the weight of the electromagnetic wave shielding material. The metal layer containing a metal selected from the group consisting of Al and Mg can contain only one of Al and Mg in one form and can contain both in another form. From the viewpoint of reducing the weight of the electromagnetic wave shielding material, one or both (preferably both) of the two metal layers included in the multilayer structure are preferably a metal layer in which the content of the metal selected from the group consisting of Al and Mg is 80.0% by mass or more, and still more preferably a metal layer in which the content of the metal selected from the group consisting of Al and Mg is 90.0% by mass or more. The metal layer containing at least Al among Al and Mg can be a metal layer in which the Al content is 80.0% by mass or more, and it can be a metal layer in which the Al content is 90.0% by mass or more. The metal layer containing at least Mg among Al and Mg can be a metal layer in which the Mg content is 80.0% by mass or more, and it can be a metal layer in which the Mg content is 90.0% by mass or more. The content of the metal selected from the group consisting of Al and Mg, the Al content, and the Mg content can be each, for example, 99.9% by mass or less. The content of the metal selected from the group consisting of Al and Mg, the Al content, and the Mg content are each the content with respect to the total mass of the metal layer.

<Resin layer>

As the resin layer that is included in the electromagnetic wave shielding material, it is possible to use, for example, a resin film commercially available as a resin film that can be used as a plastic base material, or a resin film manufactured by a known method. Examples of the resin contained in the resin layer include resin films of polyethylene terephthalate, polybutylene terephthalate, polyethylene naphthalate, polyethylene, polypropylene, cellophane, cellulose diacetate, cellulose triacetate, cellulose acetate butyrate, polyvinyl chloride, polyvinylidene chloride, polyvinyl alcohol, ethylene-vinyl acetate copolymer, polystyrene, polycarbonate, polymethylpentene, polysulfone, polyether ether ketone, polyether sulfone, polyetherimide, polyimide, fluororesin, nylon, acrylic resin, polyamide, cycloolefin, polyether sulfone, and the like. Among them, a resin film such as polyethylene terephthalate, polyethylene naphthalate, or nylon is preferable from the viewpoint of high mechanical strength. The content of the resin in the resin layer is preferably 50% by mass or more, more preferably 70% by mass or more, and still more preferably 90% by mass or more, with respect to the total mass of the resin layer. In addition, the content of the resin in the resin layer can be, for example, 100% by mass or less, less than 100%, or 99% by mass or less, with respect to the total mass of the resin layer.

In addition, in order to improve the adhesiveness to an adjacent layer, the resin layer may be subjected to a surface unevenness treatment by a sandblasting method, a solvent treatment method, or the like, and it may be subjected to a surface treatment such as a corona discharge treatment, a chromic acid treatment, a flame treatment, a hot air treatment, an ozone treatment, an ultraviolet irradiation treatment, or a surface oxidation treatment. Known techniques can be applied to these treatments.

The resin layer includes one kind or two or more kinds of resins and can also contain any amount of one or more known additives such as a plasticizer, a curing agent, a dispersing agent, a stabilizer, and a coupling agent in addition to the resin.

In one form, the glass transition temperature Tg of the resin layer can be, for example, 50°C or higher or can be 60°C or higher or 70°C or higher, and it can be, for example, 150°C or lower, 130°C or lower, or 110°C or lower. The glass transition temperature Tg in the present invention and the present specification is determined as an intermediate temperature between a descent start point and a descent end point of a differential scanning calorimetry (DSC) chart from the measurement result of the heat flow measurement using a differential scanning calorimeter. Examples of the specific example of the measuring method include the methods described in Examples described later.

<Specific example of layer configuration>

The electromagnetic wave shielding material includes one or more magnetic layers, two or more metal layers, and two or more resin layers. The total number of the magnetic layers included in the electromagnetic wave shielding material is such that, for example, one to four layers can be included. In addition, the electromagnetic wave shielding material includes one or more layers, each of which is a magnetic layer sandwiched between two metal layers, where the magnetic layer is also sandwiched between two resin layers, and the electromagnetic wave shielding material can also include two or more layers of such magnetic layers. In addition, four or fewer layers of such magnetic layers can also be included. On the other hand, the total number of the metal layers included in the electromagnetic wave shielding material is such that, for example, two to five layers can be included. The total number of the resin layers included in the electromagnetic wave shielding material is such that, for example, two to five layers can be included.

In a case where the electromagnetic wave shielding material includes only one magnetic layer, this one magnetic layer is a magnetic layer, which is a magnetic layer sandwiched between two metal layers, the magnetic layer also being sandwiched between two resin layers.

In a case where the electromagnetic wave shielding material includes two or more magnetic layers, at least one layer of these two or more magnetic layers can be a magnetic layer sandwiched between two metal layers, where the magnetic layer can be also sandwiched between two resin layers. Specifically, all or only a part of the magnetic layers included in the electromagnetic wave shielding material can be a magnetic layer sandwiched between two metal layers, where the magnetic layer can be also sandwiched between two resin layers.

Examples of the disposition of the "magnetic layer", the "metal layer", and the "resin layer" in the electromagnetic wave shielding material include the following examples.

Example 1: "resin layer 1/metal layer 1/magnetic layer 1/metal layer 2/resin layer 2"
Example 2: "metal layer 1/resin layer 1/magnetic layer 1/resin layer 2/metal layer 2"
Example 3: "resin 1/metal layer 1/magnetic layer 1/metal layer 2/magnetic layer 2/metal layer 3/resin layer 2"
Example 4: "resin layer 1/metal layer 1/magnetic layer 1/metal layer 2/magnetic layer 2/resin layer 2"
Example 5: "metal layer 1/resin layer 1/magnetic layer 1/metal layer 2/resin layer 2"

In the examples 1, 2, and 5, the magnetic layer 1 is a magnetic layer sandwiched between the metal layer 1 and the metal layer 2, and it is a magnetic layer sandwiched between the resin layer 1 and the resin layer 2.

In the example 3, the magnetic layer 1 is a magnetic layer sandwiched between the metal layer 1 and the metal layer 2, where the magnetic layer 1 is a magnetic layer that is also sandwiched between the resin layer 1 and the resin layer 2. Further, in the example 3, the magnetic layer 2 is a magnetic layer sandwiched between the metal layer 2 and the metal layer 3, where the magnetic layer 1 is a magnetic layer that is also sandwiched between the resin layer 1 and the resin layer 2. For example, as in the example 3, a pair of resin layers can sandwich each magnetic layer of two or more magnetic layers. This point also applies to a pair of metal layers. In addition, for example, as in the example 3, metal layers that sandwich a certain magnetic layer can be metal layers that sandwich another magnetic layer. This point also applies to the resin layer. For example, in the example 3, the metal layer 2 is one of the two metal layers that sandwich the magnetic layer 1, and it is also one of the two metal layers that sandwich the magnetic layer 2.

In the example 4, the magnetic layer 1 is a magnetic layer sandwiched between the metal layer 2 and the metal layer 2, where the magnetic layer 1 is a magnetic layer that is also sandwiched between the resin layer 1 and the resin layer 2. In the example 4, although the magnetic layer 2 is positioned between the resin layer 1 and the resin layer 2, it is not a magnetic layer sandwiched between two metal layers.

In each of the above examples, the symbol "/" is used in the sense of including both the fact that the layer described on the left side and the layer described on the right side of this symbol are in direct contact with each other without another layer being interposed therebetween and that they are indirectly laminated with one or more layers of other layers being interposed therebetween. Specific examples of the other layer include an adhesive layer for adhesion. In one form, the glass transition temperature Tg of the adhesive layer can be, for example, lower than 50°C, 45°C or lower, or 40°C or lower, and it can be, for example, -10°C or higher.

In one form, in the two or more metal layers included in the electromagnetic wave shielding material, both the metal layer positioned on one outermost side and the metal layer positioned on the other outermost side can be layers adjacent to the resin layer. The metal layer is preferably disposed in this way from the viewpoint of further improving forming workability. Since the metal layer positioned on the outermost side is likely to receive stress in a case of being three-dimensionally formed, the inventors of the present invention presume that in a case where such a metal layer is caused to be adjacent to the resin layer, the stress applied to the metal layer is relaxed by the resin layer, which can contribute to the suppression of breakage. Examples of such a configuration are the examples 1 to 3 and 5 described above. In a case where the total number of metal-containing layers is such that two layers are included as in Example 1, Example 2, and Example 5, the two metal layers are each a metal layer positioned on the outermost side. In the example 3, among the three metal layers, the metal layer 1 is a metal layer positioned on the one outermost side, and the metal layer 3 is a metal layer positioned on the other outermost side. The "metal layer positioned on the outermost side" associated with the two or more metal layers refers to a metal layer closest to the outer surface of the electromagnetic wave shielding material among those metal layers, which is not limited to being that such a metal layer is the outermost layer in the electromagnetic wave shielding material. The above-described outermost metal layer is, in one form, the metal layer positioned on the outermost side is the outermost layer in the electromagnetic wave shielding material, and it is, in another form, a layer other than the outermost layer in the electromagnetic wave shielding material. In addition, the term "adjacent" described above regarding the disposition of the metal layer and the resin layer shall refer to that a magnetic layer is not included between the metal layer and the resin layer, which is not limited only to a case where the metal layer and the resin layer are in direct contact with each other without another layer being interposed therebetween. A case where an adhesive layer is included between the metal layer and the resin layer shall correspond to the term "adjacent" described above. In a case where the electromagnetic wave shielding material includes a metal layer other than the above-described metal layer on the outermost side, it is preferable that such a metal layer is a layer adjacent to the resin layer from the viewpoint of further improving forming workability.

<Various thicknesses>

Thickness of magnetic layer

In a case where the electromagnetic wave shielding material includes only one magnetic layer, the thickness of this one magnetic layer can be, for example, 5 $\mu$m or more, and it is preferably 10 $\mu$m or more and more preferably 20 $\mu$m or more from the viewpoint of further improving the shielding ability against electromagnetic waves. On the other hand, the thickness of this one magnetic layer can be, for example, 100 $\mu$m or less or 90 $\mu$m or less, and it is preferably less than 90 $\mu$m, more preferably 80 $\mu$m or less, and still more preferably 70 $\mu$m or less, from the viewpoint of further improving forming workability.

In a case where the electromagnetic wave shielding material includes two or more magnetic layers, the thickness of each of the two or more magnetic layers (that is, the thickness per one layer) can be, for example, 5 $\mu$m or more, and it is preferably 10 $\mu$m or more and more preferably 20 $\mu$m or more from the viewpoint of further improving the shielding ability against electromagnetic waves. On the other hand, in this one magnetic layer, the thickness can be, for example, 100 $\mu$m or less or 90 $\mu$m or less, and it is preferably less than 90 $\mu$m and more preferably 80 $\mu$m or less, from the viewpoint of further improving forming workability. Thicknesses of each of the two or more magnetic layers can be the same thickness or thicknesses different from each other.

(Thickness of resin layer)

The electromagnetic wave shielding material includes two or more resin layers. From the viewpoint of further improving forming workability, the thickness of the resin layer is preferably 1 $\mu$m or more and more preferably 10 $\mu$m or more. In addition, the thickness per one layer of the resin layer is preferably 500 $\mu$m or less, more preferably 300 $\mu$m or less, and still more preferably 250 $\mu$m or less, from the viewpoint of easy forming into a desired shape by three-dimensional forming.

(Dp/Dm)

In a case where a thickness per one layer of the magnetic layer is denoted as Dm and a thickness per one layer of the resin layer is denoted as Dp, the thickness ratio Dp/Dm, which is a ratio of Dm to Dp, preferably satisfies the following relational expression:

$$0.17 \leq \mathrm{Dp/Dm} \leq 25.00.$$

In calculating the thickness ratio Dp/Dm, Dp and Dm are values having the same unit (for example, $\mu$m).

In a case where the electromagnetic wave shielding material includes only one magnetic layer, it is preferable that the thickness of this one magnetic layer satisfies the above-described relational expression together with one or both (preferably both) of the two resin layers that sandwich the magnetic layer.

In a case where the electromagnetic wave shielding material includes two or more magnetic layers, it is preferable that the thickness of one or more layers of these two or more magnetic layers satisfies the above-described relational expression together with one or both (preferably both) of the two resin layers that sandwich the magnetic layer. In addition, it is preferable that more magnetic layers satisfy the above-described relational expression together with one or both (preferably both) of the two resin layers that sandwich the magnetic layer. It is more preferable that the magnetic layer satisfying the above-described relational expression is a magnetic layer sandwiched between two resin layers, where the magnetic layer is also a magnetic layer sandwiched between two metal layers.

From the viewpoint of further improving one or both of the forming workability and the shielding ability against electromagnetic waves, the thickness ratio Dp/Dm is preferably 0.17 or more and more preferably 1.00 or more. In addition, from one or both of the viewpoint of further improving the forming workability and the viewpoint of easy forming into a desired shape by three-dimensional forming, the thickness ratio Dp/Dm is preferably 25.00 or less, more preferably 20.00 or less, still more preferably 15.00 or less, and even still more preferably 10.00 or less.

(Thickness of metal layer)

From the viewpoint of the workability of the metal layer and the shielding ability of the electromagnetic wave shielding material, the thickness of the metal layer in terms of the thickness per one layer is preferably 4 $\mu$m or more, more preferably 5 $\mu$m or more, and still more preferably 10 $\mu$m or more. On the other hand, from the viewpoint of the processability of the metal layer, the thickness of the metal layer in terms of the thickness per one layer is preferably

100 μm or less and more preferably 50 μm or less. In the electromagnetic wave shielding material, the thicknesses of the plurality of metal layers can be the same thickness or thicknesses different from each other.

<Manufacturing method for electromagnetic wave shielding material>

(Film formation method for magnetic layer)

The magnetic layer can be produced, for example, by drying a coating layer that is proved by applying a composition for forming a magnetic layer. The composition for forming a magnetic layer contains the components described above and can optionally contain one or more kinds of solvents. Examples of the solvent include various organic solvents, for example, ketone-based solvents such as acetone, methyl ethyl ketone, and cyclohexanone, acetic acid ester-based solvent solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone. One kind of solvent or two or more kinds of solvents selected in consideration of the solubility of the component that is used in the preparation of the composition for forming a magnetic layer can be mixed at any ratio and used. The solvent content of the composition for forming a magnetic layer is not particularly limited and may be determined in consideration of the coatability of the composition for forming a magnetic layer.

The composition for forming a magnetic layer can be prepared by sequentially mixing various components in any order or simultaneously mixing them. In addition, as necessary, a dispersion treatment can be carried out using a known dispersing machine such as a ball mill, a bead mill, a sand mill, or a roll mill, and/or a stirring treatment can be also carried out using a known stirrer such as a shaking type stirrer.

The composition for forming a magnetic layer can be applied onto, for example, a support. The coating can be carried out using a known coating device such as a blade coater or a die coater. The coating can be carried out by a so-called roll-to-roll method or a batch method.

Examples of the support onto which the composition for forming a magnetic layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. For these resin films, reference can be made to paragraphs 0081 to 0086 of JP2015-187260A. As the support, it is possible to use a support in which a surface (a surface to be coated) onto which the composition for forming a magnetic layer is applied is subjected to a peeling treatment according to a known method. One form of the peeling treatment includes forming a release layer. For the release layer, reference can be made to paragraph 0084 of JP2015-187260A. In addition, a commercially available peeling-treated resin film can also be used as the support. In a case of using a support in which the surface to be coated is subjected to the peeling treatment, it is possible to easily separate the magnetic layer and the support after the film formation.

In one form, it is also possible to directly apply the composition for forming a magnetic layer onto the metal layer using another layer as a support. For example, by directly applying the composition for forming a magnetic layer onto the metal layer or onto the resin layer, it is possible to manufacture a laminated structure of the metal layer or resin layer and the magnetic layer in one step.

A coating layer formed by applying the composition for forming a magnetic layer can be subjected to a drying treatment according to a known method such as heating or warm air blowing. The drying treatment can be carried out, for example, under conditions in which the solvent contained in the composition for forming a magnetic layer can be volatilized. As an example, the drying treatment can be carried out for 1 minute to 2 hours in a heated atmosphere having an atmospheric temperature of 80°C to 150°C.

The alignment degree of the flat-shaped particle described above can be controlled by a solvent kind, solvent amount, liquid viscosity, coating thickness, and the like of the composition for forming a magnetic layer. For example, in a case where the boiling point of the solvent is low, convection occurs due to drying, and thus the value of the alignment degree tends to be large. In a case where the solvent amount is small, the value of the alignment degree tends to increase due to physical interference between adjacent flat-shaped particles. On the other hand, in a case where the liquid viscosity is low, the rotation of flat-shaped particles is difficult to occur, and thus the value of the alignment degree tends to be small. The value of the alignment degree tends to be small as the coating thickness decreases. In addition, carrying out a pressurization treatment described later can contribute to reducing the value of the alignment degree. In a case of adjusting the various manufacturing conditions described above, the alignment degree of the flat-shaped particles can be controlled within the range described above.

(Pressurization treatment of magnetic layer)

The magnetic layer can also be subjected to a pressurization treatment after film formation. In a case of subjecting the magnetic layer containing the magnetic particles to a pressurization treatment, it is possible to increase the density of the magnetic material in the magnetic layer, and it is possible to obtain a higher magnetic permeability. In addition, in the magnetic layer containing the flat-shaped particles, it is possible to reduce the value of the alignment degree by the pressurization treatment, and it is possible to obtain a higher magnetic permeability.

The pressurization treatment can be carried out by applying pressure in the thickness direction of the magnetic layer using a flat plate pressing machine, a roll pressing machine, or the like. In the flat plate pressing machine, an object to be pressurized is disposed between two flat press plates that are disposed vertically, and the two press plates are put together by mechanical or hydraulic pressure to apply pressure to the object to be pressurized. In the roll pressing machine, an object to be pressurized is allowed to pass between the rotating pressurization rolls that are disposed vertically, and at that time, mechanical or hydraulic pressure is applied to the pressurization rolls, or the distance between the pressurization rolls is made to be smaller than the thickness of the object to be pressurized, whereby the pressure can be applied.

The pressure during the pressurization treatment can be set freely. For example, in a case of a flat plate pressing machine, it is, for example, 1 to 50 newton (N)/mm$^2$. In a case of a roll pressing machine, it is, for example, 20 to 400 N/mm in terms of the linear pressure.

The pressurization time can be set freely. It takes, for example, 5 seconds to 4 hours in a case where a flat plate pressing machine is used. In a case where a roll pressing machine is used, the pressurization time can be controlled by the transport speed of the object to be pressurized, where the transport speed is, for example, 10 cm/min to 200 m/min.

The materials of the press plate and the pressurization roll can be randomly selected from metal, ceramics, plastic, and rubber.

In the pressurization treatment, it is also possible to carry out a pressurization treatment by applying a temperature to both of upper and lower press plates of a plate-shape pressing machine or one press plate thereof, or one roll of upper and lower rolls of a roll pressing machine. The magnetic layer can be softened by heating, which makes it possible to obtain a high compression effect in a case where pressure is applied. The temperature at the time of heating can be set freely, and it is, for example, 50°C or higher and 200°C or lower. The temperature at the time of heating can be the internal temperature of the press plate or the roll. Such a temperature can be measured with a thermometer installed inside the press plate or the roll.

After the heating and pressurization treatment with the plate-shape pressing machine, the press plates can be spaced apart from each other, for example, in a state where the temperature of the press plates is high, whereby the magnetic layer can be taken out. Alternatively, the press plate can be cooled by a method such as water cooling or air cooling while maintaining the pressure, and then the press plates can be spaced apart to take out the magnetic layer.

In the roll pressing machine, the magnetic layer can be cooled immediately after pressing, by a method such as water cooling or air cooling.

It is also possible to repeat the pressurization treatment two or more times.

In a case where the magnetic layer is formed into a film on a release film, it is possible to carry out a pressurization treatment in a state where the magnetic layer is laminated on the release film. Alternatively, the magnetic layer can also be peeled off from the release film and can be subjected to a pressurization treatment as a single layer of the magnetic layer. In a case where the magnetic layer is formed into a film directly on the metal layer or on the resin layer, the pressurization treatment can be carried out in a state where the metal layer or resin layer and the magnetic layer are superposed. In addition, in a case of carrying out the pressurization treatment in a state where the magnetic layer is disposed between the metal layers or between the resin layers, it is also possible to carry out the pressurization treatment of the magnetic layer and the adhesion between the metal layer and the magnetic layer or the resin layer at the same time.

(Adhesion of two layers adjacent to each other)

Regarding the magnetic layer, the metal layer, and the resin layer, two layers adjacent to each other can be directly adhered to each other, for example, by applying pressure and heat to carry out crimping. A flat plate pressing machine, a roll pressing machine, or the like can be used for the crimping. In the crimping step, the magnetic layer is softened, and the contact with the surface of the metal layer is promoted, whereby the two layers adjacent to each other can be adhered to each other. The pressure at the time of crimping can be set freely. It is, for example, 1 to 50 N/mm$^2$ in a case of a flat plate pressing machine. In a case of a roll pressing machine, it is, for example, 20 to 400 N/mm in terms of the linear pressure. The pressurization time at the time of crimping can be set freely. It takes, for example, 5 seconds to 30 minutes in a case where a flat plate pressing machine is used. In a case where a roll pressing machine is used, the pressurization time can be controlled by a transport speed of an object to be pressurized, and the transport speed is, for example, 10 cm/min to 200 m/min. The temperature at the time of crimping can be randomly selected. For example, it is 50°C or higher and 200°C or lower.

The two layers adjacent to each other can also be adhered to each other with an adhesive layer being interposed therebetween. The adhesive layer can be formed by using an adhesion means such as a double-sided tape or an adhesive. The general double-sided tape and the adhesive do not affect the shielding ability of the shielding material, or the influence thereof is as small as negligible. Examples of the adhesive means include the double-sided tape described as a silicone-based base material-less double-sided tape in JP2003-20453A. In addition, a double-sided tape and an adhesive, which are commercially available, can also be used. The thickness of the adhesive layer formed from the double-sided tape or the adhesive is not particularly limited; however, it can be, for example, 1 $\mu$m or more and 30 $\mu$m or less.

In one form, it is possible to use a commercially available product in which a resin layer and a metal layer are laminated, for manufacturing the electromagnetic wave shielding material. Such a commercially available product can be, for example, a laminate in which a resin layer and a metal layer are adhered to each other with an adhesive layer being interposed therebetween. Specific examples of the commercially available product of such a laminate include AL-PET (manufactured by PANAC CO., LTD.) in which a polyethylene terephthalate (PET) film and an aluminum foil are adhered with an adhesive layer being interposed therebetween.

The electromagnetic wave shielding material can be incorporated into, in any shape, an electronic component or an electronic apparatus. The electromagnetic wave shielding material can have a sheet shape, where the size thereof is not particularly limited. In the present invention and the present specification, the "sheet" has the same meaning as the "film". In addition, the electromagnetic wave shielding material can be a three-dimensional formed article obtained by three-dimensionally forming a sheet-shaped electromagnetic wave shielding material, or it can also be a sheet-shaped electromagnetic wave shielding material for three-dimensional forming. Examples of the three-dimensional forming method include air pressure forming method and a vacuum forming method. The air pressure forming method is a forming method in which in a state of being heated and softened, a sheet-shaped forming target is closely attached to a forming die with compressed air to form the forming target into a three-dimensional shape. The vacuum forming method is a forming method in which in a state where a sheet-shaped forming target is heated and softened, a space between the forming target and the forming die is made into a vacuum state, whereby the forming target is closely attached to the forming die to be formed into a three-dimensional shape. The electromagnetic wave shielding material can be an electromagnetic wave shielding material that is difficult to be broken in a case of being formed by such a three-dimensional forming method. Known techniques can be applied to the three-dimensional forming method.

[Electronic component]

One aspect of the present invention relates to an electronic component including the electromagnetic wave shielding material. Examples of the electronic component include an electronic component included in an electronic apparatus such as a mobile phone, a mobile information terminal, and a medical device, and various electronic components such as a semiconductor element, a capacitor, a coil, and a cable. The electromagnetic wave shielding material is three-dimensionally formed into any shape, for example, according to the shape of the electronic component, thereby capable of being disposed in the inside of the electronic component, or it is three-dimensionally formed into a shape of a cover material, thereby capable of being disposed as a cover material that covers the outside of the electronic component. Alternatively, it can be three-dimensionally formed into a tubular shape, thereby being disposed as a cover material that covers the outside of the cable.

[Electronic apparatus]

One aspect of the present invention relates to an electronic apparatus including the electromagnetic wave shielding material. Examples of the electronic apparatus include electronic apparatuses such as a mobile phone, a mobile information terminal, and a medical device, electronic apparatuses including various electronic components such as a semiconductor element, a capacitor, a coil, and a cable, and electronic apparatuses in which electronic components are mounted on a circuit board. Such an electronic apparatus can include the electromagnetic wave shielding material as a constitutional member of an electronic component included in the device. In addition, as a constitutional member of the electronic apparatus, the electromagnetic wave shielding material can be disposed in the inside of the electronic apparatus or can be disposed as a cover material that covers the outside of the electronic apparatus. Alternatively, it can be three-dimensionally formed into a tubular shape, thereby being disposed as a cover material that covers the outside of the cable.

Examples of the usage form of the electromagnetic wave shielding material include a usage form in which a semiconductor package on a printed board is coated with a shielding material. For example, "Electromagnetic wave shielding technology in a semiconductor package" (Toshiba Review Vol. 67, No. 2 (2012) P. 8) discloses a method of obtaining a high shielding effect by electrically connecting a side via of an end part of a package substrate and an inner surface of a shielding material in a case where a semiconductor package is coated with a shielding material, thereby carrying out ground wiring. In order to carry out such wiring, it is desirable that the outermost layer of the shielding material on the electronic component side is a metal layer. In one form, since one or both of outermost layers of the shielding material can be a metal layer in the electromagnetic wave shielding material, the electromagnetic wave shielding material can be suitably used in a case of carrying out the wiring as described above.

Examples

Hereinafter, the present invention will be described in more detail with reference to Examples. However, the present invention is not limited to the embodiments shown in Examples.

[Example 1]

<Preparation of coating liquid>

To a plastic bottle, the following substances were added and mixed with a shaking type stirrer for 1 hour to prepare a coating liquid;

100 g of Fe-Si-Al flat-shaped magnetic particles (Sendust MFS-SUH manufactured by MKT),
38 g of a polyester urethane resin (UR-8300, manufactured by TOYOBO Co., Ltd.),
0.5 g of a polyfunctional isocyanate (CORONATE L manufactured by Tosoh Corporation), and
205 g of cyclohexanone.

<Production of magnetic layer>

(Film formation for magnetic layer)

A coating liquid was applied onto a peeling surface of a peeling-treated PET film (PET75TR manufactured by NIPPA Co., Ltd.) with a blade coater having a coating gap of 300 $\mu$m and dried for 30 minutes in a drying device having an internal atmospheric temperature of 80°C to form a film of a film-shaped magnetic layer.

(Pressurization treatment of magnetic layer)

Upper and lower press plates of a plate-shape pressing machine (a large-scale hot press TA-200-1W manufactured by YAMAMOTO ENG. WORKS Co., LTD.) were heated to 140°C (the internal temperature of the press plate), and the magnetic layer on the release film was installed in the center of the press plate together with the release film and held for 10 minutes in a state where a pressure of 4.66 N/mm$^2$ was applied. The upper and lower press plates were cooled to 50°C (the internal temperature of the press plates) while maintaining the pressure, and then the magnetic layer was taken out together with the release film.

<Production of shielding material>

A sample piece for each of the evaluations of the following measurement of magnetic permeability and the following measurement of electrical conductivity was cut off from a part of the magnetic layer after the release film was peeled off. A double-sided tape (NeoFix 5 S2 manufactured by NEION Film Coatings Corp.) having a thickness of 5 $\mu$m was bonded to the upper and lower surfaces of the magnetic layer after the sample piece had been cut out, and a copper foil having a thickness of 10 $\mu$m (conforming to the JIS H3100: 2018 standard, alloy number: C1100R, copper content: 99.90% by mass or more) was further bonded to each of the upper and lower surfaces.
Further, a double-sided tape (NeoFix 5 S2 manufactured by NEION Film Coatings Corp.) having a thickness of 5 $\mu$m was bonded to each of the upper and lower surfaces to which the copper foil had been bonded, and further, a commercially available PET film (manufactured by Toray Industries, Inc., product name: Lumirror, model number: #100-S10) having a thickness of 100 $\mu$m was bonded to each of the upper and lower surfaces. The resin content of this commercially available PET film is 98% by mass or more.
In this way, a sheet-shaped shielding material of Example 1, which included a multilayer structure of "PET film (resin layer) / copper foil (metal layer) / magnetic layer / copper foil (metal layer) / PET film (resin layer)", was produced.

<Measurement of magnetic permeability>

The magnetic layer was cut into a rectangle having a size of 28 mm $\times$ 10 mm, the magnetic permeability was measured using a magnetic permeability measuring apparatus (PER01 manufactured by KEYCOM Corporation), and the magnetic permeability was determined as the real part ($\mu'$) of the complex specific magnetic permeability at a frequency of 100 kHz. The determined magnetic permeability was 148.

<Measurement of electrical conductivity>

A cylindrical main electrode having a diameter of 30 mm was connected to the negative electrode side of a digital super-insulation resistance meter (TR-811A manufactured by Takeda RIKEN Industries), a ring electrode having an inner diameter of 40 mm and an outer diameter of 50 mm was connected to the positive electrode side thereof, the main electrode was installed on a sample piece of the magnetic layer cut to a size 60 mm × 60 mm, the ring electrode was installed at a position surrounding the main electrode, a voltage of 25 V was applied to both electrodes, and the surface electrical resistivity of the magnetic layer alone was measured. The electrical conductivity of the magnetic layer was calculated from the surface electrical resistivity and the following expression. The calculated electrical conductivity was $1.1 \times 10^{-2}$ S/m.

As the thickness, the thickness of the magnetic layer, which had been determined according to the following method, was used.

$$\text{Electrical conductivity [S/m]} = 1/(\text{surface electrical resistivity } [\Omega] \times \text{thickness [m]})$$

<Acquisition of cross-sectional image of shielding material>

Cross-section processing was carried out to expose the cross-section of the shielding material of Example 1 according to the following method.

A shielding material cut out to a size of 3 mm × 3 mm was embedded in a resin, and a cross section of the shielding material was cut with an ion milling device (IM4000PLUS manufactured by Hitachi High-Tech Corporation).

The cross-section of the shielding material, which had been exposed in this way, was observed with a scanning electron microscope (SU8220, manufactured by Hitachi High-Tech Corporation) under the conditions of an acceleration voltage of 2 kV and a magnification of 100 times to obtain a backscattered electron image. From the obtained image, the thicknesses of the magnetic layer, the two metal layers, and the two resin layers were measured at five points based on the scale bar, and the arithmetic averages of the respective thicknesses were denoted as the thickness of the magnetic layer, the thickness of each of the two metal layers, and the thickness of each of the two resin layers.

<Acquisition of cross-sectional image of magnetic layer>

In a cross section of the shielding material of Example 1, which had been exposed by the cross-section processing in the same manner as described above, a portion of the magnetic layer was observed with a scanning electron microscope (SU8220, manufactured by Hitachi High-Tech Corporation) under the conditions of an acceleration voltage of 2 kV and a magnification of 1,000 times, thereby obtaining a backscattered electron image.

<Measurement of aspect ratio of magnetic particle and alignment degree of flat-shaped particle>

Using the backscattered electron image acquired as above, the aspect ratio of the magnetic particles was determined according to the method described above, and the flat-shaped particles were specified from the value of the aspect ratio. As a result of determining, as described above, whether or not the magnetic layer contained flat-shaped particles as the magnetic particles, it was determined that the magnetic layer contains flat-shaped particles. Further, as a result of determining the alignment degree of the magnetic particles specified as the flat-shaped particles, according to the method described above, the alignment degree was 13°. In addition, an average value (arithmetic average) of the aspect ratios of all the particles specified as the flat-shaped particles was determined as the aspect ratio of the flat-shaped particles contained in the magnetic layer. The determined aspect ratio was 0.071.

<Evaluation of shielding ability (KEC method)>

A shielding material cut to a size of 150 mm × 150 mm was installed between antennas of a KEC method evaluation device including a signal generator, an amplifier, a pair of magnetic field antennas, and a spectrum analyzer, and at a frequency of 100 kHz and a frequency of 10 MHz, a ratio of the intensity of the received signal in a case where the shielding material was not present to the intensity of the received signal in a case where the shielding material was present was determined and denoted as the shielding ability. The operation was carried out with the magnetic field antenna to determine the magnetic field wave shielding ability. From the determined magnetic field wave shielding ability, the electromagnetic wave shielding ability was evaluated according to the following evaluation standards. It is noted that KEC is an abbreviation for Kansai Electronic Industry Development Center.

(Evaluation standards)

> A: 10 dB or more at 100 kHz and 70 dB or more at 10 MHz
> B: 10 dB or more at 100 kHz and less than 70 dB at 10 MHz
> C: Less than 10 dB at 100 kHz and less than 70 dB at 10 MHz

<Evaluation of forming workability>

The sheet-shaped electromagnetic wave shielding material of Example 1 was subjected to air pressure forming to produce a hemispherical three-dimensional formed article. The presence or absence of breakage in the produced three-dimensional formed article was visually checked, and from the checking results, the forming workability was evaluated according to the following evaluation standards.

(Evaluation standards)

> A: A three-dimensional formed article having a depth of 3 cm can be formed without breakage by using a hemispherical forming die having a depth of 3 cm.
> B: A three-dimensional formed article having a depth of 2 cm can be formed without breakage by using a hemispherical forming die having a depth of 2 cm. Further, in a case where a hemispherical forming die having a depth of 3 cm was used, the breakage was observed in the obtained three-dimensional formed article having a depth of 3 cm, or a three-dimensional formed article having a depth of 3 cm was not obtained.
> C: The breakage is observed in the three-dimensional formed article having a depth of 2 cm can be formed without breakage by using a hemispherical forming die having a depth of 2 cm.

<Overall evaluation>

In a case where the evaluation results of the shielding ability and the forming workability were A, the overall evaluation was evaluated as "A". In a case where one of the evaluation results of the shielding ability and the forming workability was A and the other was B, the overall evaluation was evaluated as "B". In a case where at least one of the evaluation results of the shielding ability or the forming workability was C, the overall evaluation was evaluated as "C".

[Example 2]

A magnetic layer was produced by the method described for Example 1.
Using the same copper foil as the copper foil used as the metal layer in Example 1, and using the same PET film as the PET film used as the resin layer in Example 1, five layers of "copper foil/ PET film/ magnetic layer / PET film/ copper foil" were bonded by disposing, at each of the interfaces in the five layers, the same double-sided tape as the double-sided tape used in Example 1.
In this way, a sheet-shaped shielding material of Example 2, which included a multilayer structure of "copper foil (metal layer) / PET film (resin layer) / magnetic layer / PET film (resin layer) / copper foil (metal layer)", was produced.

[Example 3]

A magnetic layer was produced by the method described for Example 1, except that a coating gap of a blade coater was changed in order to reduce the thickness of the magnetic layer.
A sheet-shaped shielding material of Example 3, which included a multilayer structure of "PET film (resin layer) / copper foil (metal layer) / magnetic layer / copper foil (metal layer) / PET film (resin layer)", was produced by the method described for Example 1, except that the above-described magnetic layer was used, and a commercially available PET film (manufactured by Toray Industries, Inc., product name: Lumirror, model number: #250-S10) having a thickness of 250 μm was used as the PET film.

[Example 4]

A magnetic layer was produced by the method described for Example 1, except that a coating gap of a blade coater was changed in order to reduce the thickness of the magnetic layer.

A sheet-shaped shielding material of Example 4, which included a multilayer structure of "PET film (resin layer) / copper foil (metal layer) / magnetic layer / copper foil (metal layer) / PET film (resin layer)", was produced by the method described for Example 1, except that the above-described magnetic layer was used, and a commercially available PET film (manufactured by Toray Industries, Inc., product name: Lumirror, model number: #350-S10) having a thickness of 350 $\mu$m was used as the PET film.

[Example 5]

A magnetic layer was produced by the method described for Example 1, except that a coating gap of a blade coater was changed in order to increase the thickness of the magnetic layer.

A sheet-shaped shielding material of Example 5, which included a multilayer structure of "PET film (resin layer) / copper foil (metal layer) / magnetic layer / copper foil (metal layer) / PET film (resin layer)", was produced by the method described for Example 1, except that the above-described magnetic layer was used, and a commercially available PET film (manufactured by Toray Industries, Inc., product name: Lumirror, model number: #12-S10) having a thickness of 12 $\mu$m was used as the PET film.

[Example 6]

A magnetic layer was produced by the method described for Example 1, except that a coating gap of a blade coater was changed in order to reduce the thickness of the magnetic layer.

A sheet-shaped shielding material of Example 6, which included a multilayer structure of "PET film (resin layer) / copper foil (metal layer) / magnetic layer / copper foil (metal layer) / PET film (resin layer)", was produced by the method described for Example 1, except that the above-described magnetic layer was used, and a commercially available PET film (manufactured by Toray Industries, Inc., product name: Lumirror, model number: #250-S10) having a thickness of 250 $\mu$m was used as the PET film.

[Example 7]

A magnetic layer was produced by the method described for Example 1, except that a coating gap of a blade coater was changed in order to increase the thickness of the magnetic layer.

A sheet-shaped shielding material of Example 7, which included a multilayer structure of "PET film (resin layer) / copper foil (metal layer) / magnetic layer / copper foil (metal layer) / PET film (resin layer)", was produced by the method described for Example 1, except that the above-described magnetic layer was used, and a commercially available PET film (manufactured by Toray Industries, Inc., product name: Lumirror, model number: #12-S10) having a thickness of 12 $\mu$m was used as the PET film.

[Example 8]

A sheet-shaped shielding material of Example 8, which included a multilayer structure of "PET film (resin layer) /aluminum foil (metal layer) / magnetic layer /aluminum foil (metal layer) / PET film (resin layer)", was produced by the method described for Example 1, except that each of the two copper foils was changed to an aluminum foil having a thickness of 15 $\mu$m (conforming to the JIS H4160: 2006 standard, alloy number: 1N30 with temper designation of (1)O, Al content: 99.3% by mass or more).

[Example 9]

A magnetic layer was produced by the method described for Example 1.

Using the same copper foil as the copper foil used as the metal layer in Example 1, and using the same PET film as the PET film used as the resin layer in Example 1, seven layers of "PET film/ copper foil/ magnetic layer / copper foil/ magnetic layer / copper foil/ PET film" were bonded by disposing, at each of the interfaces in the five layers, the same double-sided tape as the double-sided tape used in Example 1.

In this way, a sheet-shaped shielding material of Example 9, which included a multilayer structure of "PET film (resin layer) / copper foil (metal layer) / magnetic layer / copper foil (metal layer) / magnetic layer / copper foil (metal layer) / PET film (resin layer) /", was produced.

[Example 10]

A magnetic layer was produced by the method described for Example 1.
Using the same copper foil as the copper foil used as the metal layer in Example 1, and using the same PET film as the PET film used as the resin layer in Example 1, six layers of "PET film/ copper foil/ magnetic layer / copper foil/ magnetic layer / PET film" were bonded by disposing, at each of the interfaces in the five layers, the same double-sided tape as the double-sided tape used in Example 1.
In this way, a sheet-shaped shielding material of Example 10, which included a multilayer structure of "PET film (resin layer) / copper foil (metal layer) / magnetic layer / copper foil (metal layer) / magnetic layer / PET film (resin layer), was produced.

[Example 11]

A sheet-shaped shielding material of Example 11, which included a multilayer structure of "PET film (resin layer) / copper foil (metal layer) / magnetic layer / copper foil (metal layer) / PET film (resin layer)", was produced by the method described for Example 1, except that the composition of the coating liquid for the magnetic layer was changed to 100 g of Fe-Si-Al flat-shaped magnetic particles (Sendust MFS-SUH manufactured by MKT), 11 g of a silicone resin (KR-220LP, manufactured by Shin-Etsu Chemical Co., Ltd.), and 205 g of methyl ethyl ketone, and the pressurization time of the magnetic layer was changed from 10 to 2 hours.

[Example 12]

A sheet-shaped shielding material of Example 12, which included a multilayer structure of " 6-nylon film (resin layer) / copper foil (metal layer) / magnetic layer / copper foil (metal layer) /6-nylon film (resin layer)", was produced by the method described for Example 1, except that a commercially available 6-nylon film (manufactured by Mitsubishi Chemical Corporation, product name: SNR25) having a thickness of 25 $\mu$m was used as the resin layer instead of the PET film. The resin content of the 6-nylon film is 98% by mass or more.

[Example 13]

A sheet-shaped shielding material of Example 13, which included a multilayer structure of "PET film (resin layer) /aluminum foil (metal layer) / magnetic layer /aluminum foil (metal layer) / PET film (resin layer)", was produced by the method described for Example 1, except that AL-PET AL/PET50-50K manufactured by PANAC CO., LTD. (a laminate in which an aluminum foil having a thickness of 50 $\mu$m and a PET film having a thickness of 50 $\mu$m were adhered to each other with an adhesive layer having a thickness of 2 $\mu$m being interposed therebetween), in which a resin layer and a metal layer were adhered to each other with an adhesive layer being interposed therebetween, was used. The resin content of the PET film is 98% by mass or more.

[Comparative Example 1]

Using the same copper foil as the copper foil used as the metal layer in Example 1, and using the same PET film as the PET film used as the resin layer in Example 1, five layers of "PET film/copper foil/PET film/copper foil/PET film" were bonded by disposing, at each of the interfaces in the five layers, the same double-sided tape as the double-sided tape used in Example 1.
In this way, a sheet-shaped shielding material of Comparative Example 1, which included a multilayer structure of "PET film (resin layer)/copper foil (metal layer)/PET film (resin layer)/copper foil (metal layer)/PET film (resin layer), was produced.

[Comparative Example 2]

A sheet-shaped shielding material of Comparative Example 2, which included a multilayer structure of "copper foil (metal layer) / magnetic layer / copper foil (metal layer)", was produced by the method described for Example 1, except that the PET film was not bonded using a double-sided tape.

[Comparative Example 3]

A magnetic layer was produced by the method described for Example 1.
Using the same copper foil as the copper foil used as the metal layer in Example 1, and using the same PET film as the PET film used as the resin layer in Example 1, five layers of "magnetic layer / copper foil/ PET film/ copper foil/ PET film" were bonded by disposing, at each of the interfaces in the five layers, the same double-sided tape as the double-sided tape used in Example 1.

In this way, a sheet-shaped shielding material of Comparative Example 3, which included a multilayer structure of "magnetic layer / copper foil (metal layer) / PET film (resin layer) / copper foil (magnetic layer) / PET film (resin layer)", was produced.

The shielding material of each of Examples 2 to 13 and Comparative Examples 1 to 3 was subjected to various evaluations according to the method described for Example 1.

For Examples 1 to 12 and Comparative Examples 1 to 3, the glass transition temperature Tg of each of the PET film and the 6-nylon film used as the resin layer, and the glass transition temperature Tg of the double-sided tape used as the adhesive layer were measured according to the following method. The measurement results were as follows. Glass transition temperature of PET film: 80°C, glass transition temperature of 6-nylon film: 50°C, glass transition temperature of double-sided tape: 10°C.

<Measuring method for glass transition temperature Tg>

A specimen to be measured was cut out from each of the PET film, the 6-nylon film, and the double-sided tape. Each specimen to be measured was subjected to a heat flow measurement under the following conditions using DSC6200 manufactured by SII Crystal Technology Inc. as a differential scanning calorimeter. A temperature raising and lowering cycle was carried out twice for the same specimen to be measured, and the second measurement result (2nd-heating) was adopted to determine the glass transition temperature Tg.

(Measurement conditions)

    Atmosphere in measurement room: Nitrogen (50 mL/min)
    Temperature rising rate: 10 °C/min
    Measurement start temperature: 0°C
    Measurement end temperature: 200°C
    Specimen pan: aluminum pan
    Mass of specimen to be measured: 5 mg
    Calculation of glass transition temperature Tg: An intermediate temperature between the descent start point and the descent end point of the DSC chart was defined as Tg.

Regarding Examples 1 to 13 and Comparative Examples 1 to 3, in a case where one shielding material included a plurality of metal layers, the thickness of the metal layer measured by the above-described method was the same value regarding any metal layer. This point was the same in a case where one shielding material included a plurality of resin layers and in a case where one shielding material included a plurality of magnetic layers. In Table 1, the thickness per one layer of the magnetic layer determined as described above is shown as Dm, the thickness per one layer of the resin layer determined as described above is shown as Dp, and the thickness ratio Dp/Dm calculated from Dm and Dp is also shown. The thickness of each metal layer was the thickness described above for the metal foil (the copper foil or the aluminum foil).

The above results are shown in Table 1. In Table 1, "PET" indicates a PET film, "PA6" indicates a 6-nylon film (PA is an abbreviation for polyamide), "Cu" indicates a copper foil, and "Al" indicates an aluminum foil.

[Table 1]

| | Configuration of shielding material | | | | | | | Thickness per one layer of resin layer Dp (µm) | Thickness per one layer of magnetic layer Dm (µm) | Thickness ratio Dp/Dm | Shielding ability | Forming workability | Overall evaluation |
|---|---|---|---|---|---|---|---|---|---|---|---|---|---|
| | 1st layer | 2nd layer | 3rd layer | 4th layer | 5th layer | 6th layer | 7th layer | | | | | | |
| Example 1 | PET | Cu | Magnetic layer | Cu | PET | - | - | 100 | 30 | 3.33 | A | A | A |
| Example 2 | Cu | PET | Magnetic layer | PET | Cu | - | - | 100 | 30 | 3.33 | A | A | A |
| Example 3 | PET | Cu | Magnetic layer | Cu | PET | - | - | 250 | 8 | 31.25 | B | A | B |
| Example 4 | PET | Cu | Magnetic layer | Cu | PET | - | - | 350 | 11 | 31.82 | A | B | B |
| Example 5 | PET | Cu | Magnetic layer | Cu | PET | - | - | 12 | 90 | 0.13 | A | B | B |
| Example 6 | PET | Cu | Magnetic layer | Cu | PET | - | - | 250 | 10 | 25.00 | A | A | A |
| Example 7 | PET | Cu | Magnetic layer | Al | PET | - | - | 12 | 70 | 0.17 | A | A | A |
| Example 8 | PET | Al | Magnetic layer | Cu | Magnetic layer | Cu | PET | 100 | 30 | 3.33 | A | A | A |
| Example 9 | PET | Cu | Magnetic layer | Cu | Magnetic layer | PET | - | 100 | 30 | 3.33 | A | A | A |
| Example 10 | PET | Cu | Magnetic layer | Cu | PET | - | - | 100 | 30 | 3.33 | A | B | B |
| Example 11 | PET | Cu | Magnetic layer | Cu | PA6 | - | - | 100 | 30 | 3.33 | A | A | A |
| Example 12 | PA6 | Cu | Magnetic layer | Cu | PET | - | - | 25 | 30 | 0.83 | A | A | A |
| Example 13 | PET | Al | Magnetic layer | Cu | PET | - | - | 50 | 30 | 1.67 | A | A | A |
| Comparative Example 1 | PET | Cu | PET | - | - | - | - | 100 | Without magnetic layer | - | C | A | C |
| Comparative Example 2 | Cu | Magnetic layer | Cu | - | - | - | - | Without resin layer | 30 | - | A | C | C |
| Comparative Example 3 | Magnetic layer | Cu | PET | Cu | PET | - | - | 100 | 30 | 3.33 | C | B | C |

[Industrial applicability]

One aspect of the present invention is useful in the technical fields of various electronic components and various electronic apparatuses.

**Claims**

1. An electromagnetic wave shielding material comprising:

   one or more magnetic layers;
   two or more metal layers; and
   two or more resin layers,
   wherein each of the included one or more layers of the magnetic layers is a magnetic layer sandwiched between two metal layers, where the magnetic layer is also sandwiched between two resin layers.

2. The electromagnetic wave shielding material according to claim 1,
   wherein a total number of the magnetic layers included in the electromagnetic wave shielding material is such that one layer is included, where a thickness of the magnetic layer is 10 $\mu$m or more

3. The electromagnetic wave shielding material according to claim 2,
   wherein in a case where a thickness per one layer of the magnetic layer is denoted as Dm and a thickness per one layer of the resin layer is denoted as Dp, the magnetic layer satisfies the following relational expression together with one or both of two resin layers that sandwich the magnetic layer;

$$0.17 \leq \mathrm{Dp/Dm} \leq 25.00.$$

4. The electromagnetic wave shielding material according to claim 1,
   wherein a total number of the magnetic layers included in the electromagnetic wave shielding material is such that two or more layers are included, where a thickness of each of the two or more magnetic layers is 10 $\mu$m or more.

5. The electromagnetic wave shielding material according to claim 4,
   wherein in a case where a thickness per one layer of the magnetic layer is denoted as Dm and a thickness per one layer of the resin layer is denoted as Dp, one or more layers in the two or more magnetic layers satisfies the following relational expression together with one or both of two resin layers that sandwich the magnetic layer;

$$0.17 \leq \mathrm{Dp/Dm} \leq 25.00.$$

6. The electromagnetic wave shielding material according to any one of claims 1 to 5,
   wherein a glass transition temperature of the resin layer is 50°C or higher.

7. The electromagnetic wave shielding material according to any one of claims 1 to 6,
   wherein in the two or more metal layers included in the electromagnetic wave shielding material, both the metal layer positioned on one outermost side and the metal layer positioned on the other outermost side are layers adjacent to the resin layer.

8. The electromagnetic wave shielding material according to any one of claims 1 to 7,
   wherein the magnetic layer is a layer containing metal particles as magnetic particles.

9. The electromagnetic wave shielding material according to claim 8,
   wherein the magnetic layer is a layer further containing a resin.

10. An electronic component comprising:
    the electromagnetic wave shielding material according to any one of claims 1 to 9.

11. An electronic apparatus comprising:
    the electromagnetic wave shielding material according to any one of claims 1 to 9.

## INTERNATIONAL SEARCH REPORT

<table>
<tr><td>International application No.</td></tr>
<tr><td>**PCT/JP2022/019488**</td></tr>
</table>

### A. CLASSIFICATION OF SUBJECT MATTER

*H05K 9/00*(2006.01)i; *B32B 7/025*(2019.01)i; *B32B 15/08*(2006.01)i; *H01F 1/26*(2006.01)i
FI: H05K9/00 W; B32B7/025; B32B15/08 D; H01F1/26

According to International Patent Classification (IPC) or to both national classification and IPC

### B. FIELDS SEARCHED

Minimum documentation searched (classification system followed by classification symbols)

H05K9/00; B32B7/025; B32B15/08; H01F1/26

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2021-28940 A (TOYO INK SC HOLDINGS CO LTD) 25 February 2021 (2021-02-25) paragraphs [0002], [0007], [0012], [0028], [0029], [0033], [0036], [0060], [0077], fig. 3 | 1, 4-11 |
| A | paragraphs [0002], [0007], [0012], [0028], [0029], [0033], [0036], [0060], [0077], fig. 3 | 2-3 |

☐ Further documents are listed in the continuation of Box C.　　☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **25 July 2022** | **02 August 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/019488**

| Patent document cited in search report | Publication date (day/month/year) | Patent family member(s) | Publication date (day/month/year) |
|---|---|---|---|
| JP 2021-28940 A | 25 February 2021 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3006898 A
- JP H36898 A
- JP 2008192792 A
- JP 2018131640 A
- JP 2015187260 A
- JP 2003020453 A